# EUROPEAN PATENT SPECIFICATION

(11) **EP 3 734 644 B1**
(45) Date of publication and mention of the grant of the patent: **22.05.2024**
(21) Application number: 18895298.0
(22) Date of filing: 10.12.2018
(51) Int. Cl.: H01L 21/263, H01L 21/223

(54) **CONTROL METHOD FOR RECOMBINATION LIFETIMES**
STEUERUNGSVERFAHREN FÜR REKOMBINATIONSLEBENSDAUERN
PROCÉDÉ DE COMMANDE POUR DURÉES DE VIE DE RECOMBINAISON

(30) Priority: 28.12.2017 JP 2017254431
(43) Date of publication of application: 04.11.2020
(73) Proprietor: Shin-Etsu Handotai Co., Ltd., Tokyo 100-0004 (JP)
(72) Inventor: TAKENO, Hiroshi, Annaka-shi, Gunma 379-0196 (JP)
(74) Representative: Wibbelmann, Jobst
(86) International application number: PCT/JP2018/045201
(87) International publication number: WO 2019/131074

(56) References cited:
- JP-A- 2002 110 687
- JP-A- 2008 103 673
- JP-A- 2010 003 899
- JP-A- 2015 198 166
- JP-A- 2016 127 192
- US-A1- 2014 097 488
- DIETZE W ET AL: "FLOAT-ZONE GROWN SILICON", CRYSTALS, GROWTH, PROPERTIES AND APPLICATIONS, SPRINGER VERLAG, BERLIN, DE, vol. 5, 1 January 1981 (1981-01-01), pages 1-42, XP000579156,

## Description

### TECHNICAL FIELD

The present invention relates to: a method for controlling recombination lifetime of carriers in a silicon single crystal substrate.

### BACKGROUND ART

In power devices such as an insulated gate bipolar transistor (Insulated Gate Bipolar Transistor: IGBT) or a diode, there has been conventionally adopted a technology which intentionally introduces a defect which becomes a recombination center of carriers into a silicon substrate and controls a recombination lifetime of the carriers to be shortened, thereby increasing a switching speed, and consequently reducing switching loss.

As methods for controlling recombination lifetime, there are a method of diffusing heavy metal impurities such as gold or platinum into a substrate and a method of applying charged particle beams (which may be referred to as particle beams) of electron beams, protons, or helium ions or the like. In the method of diffusing heavy metal impurities, since control over concentration, a distribution in a depth direction, or radial uniformity is difficult, charged particle beam irradiation has been often used in recent years (see Patent Documents 1 to 3). In the case of applying the charged particle beams, since a plurality of types of defects which become recombination centers are introduced near room temperature and thermally unstable defect types are present among them, a heat treatment (which may be also referred to as a recovery heat treatment) is further performed after applying the charged particle beams to annihilate the thermally unstable defects, or defect concentration is adjusted to obtain a target value of the recombination lifetime.

For example, in Patent Document 3, there is a description that, to reduce a reverse recovery time of a diode, a heat treatment may be performed under heat treatment conditions to make crystal defects caused by electron beam irradiation remain, and a recombination lifetime of carriers may be set to approximately 0.1 to 1 (µsec). Further, in Patent Document 3, there is also a description that the heat treatment conditions in this case are preferably set so that a heat treatment temperature is 350°C or more and less than 380°C and a heat treatment time can range from 0.5 hours to approximately 2 hours, for example. Furthermore, in Patent Document 4, there is a description that, when a heat treatment temperature is 400°C or more, a lifetime of a wafer irradiated with protons is approximately 10 µs, which is desirable in terms of control over a diode forward voltage, the reverse recovery loss, and the like.

The switching loss and steady loss in power devices have a tradeoff relationship, and hence strict control over the recombination lifetime is required to reduce overall loss.

Moreover, in breakdown voltage characteristics of power devices, since formation of an oxygen donor in a silicon single crystal substrate which causes a variation in resistivity of the silicon substrate becomes a problem, an FZ (Floating Zone) silicon single crystal substrate which hardly contains oxygen or a silicon single crystal substrate having oxygen concentration extremely lowered by an MCZ method provided by adding application of a magnetic field to a CZ method are often used in high-performance devices.

In this event, in an FZ silicon single crystal substrate, nitrogen is often added at the time of crystal growth to prevent an electric discharge in a furnace at the time of crystal growth, reduce crystal defects introduced at the time of crystal growth, and improve wafer strength (Patent Document 5). The concentration of the nitrogen introduced into the grown single crystal is controlled by adjusting an atmospheric gas at the time of crystal growth.

### CITATION LIST

### PATENT LITERATURE

Patent Document 1: Japanese Unexamined Patent Application Publication No. H11-135509
Patent Document 2: Japanese Unexamined Patent Application Publication No. 2000-200792
Patent Document 3: International Publication No. 2013/100155
Patent Document 4: International Publication No. 2007/055352
Patent Document 5: Japanese Unexamined Patent Application Publication No. 2017-122033
Patent Document 6: Japanese Unexamined Patent Application Publication No. 2015-198166
Patent Document 7: Japanese Unexamined Patent Application Publication No. 2016-127192
Patent Document 8: US2014097488

### NON PATENT LITERATURE

Non Patent Document 1: Kiyoi et al., The 61st Japan Society of Applied Physics Spring Meeting, Meeting Proceedings, 19p-F9-14.
Non Patent Document 2: Minato et al., The 4th Workshop on Power Device Silicon and Related Semiconductor Materials, p. 77.
Non Patent Document 3: K. Takano et al., Proceeding of the 27th International Symposium on Power Semiconductor Devices & IC's, 2015, P. 129.
Non Patent Document 4: Sugiyama et al., Silicon Technology No. 87, P. 6.
Non Patent Document 5: Sugie et al., Silicon Technology No. 148. p. 11.
Non Patent Document 6: N. Inoue et al., Physica B 401-402 (2007), p. 477.

### SUMMARY OF INVENTION

### TECHNICAL PROBLEM

However, even if conditions for particle beam irradiation or conditions for a heat treatment after the particle beam irradiation are equalized, there still remains a problem that device characteristics vary (Non Patent Documents 1 to 3). Since a variation in recombination lifetime directly affects a variation in device characteristics, improving the variation in recombination lifetime is a very important problem. In recent years in particular, with an improvement in performance of semiconductor devices, recombination lifetime must be highly precisely controlled, and a variation thereof must be reduced as much as possible.

As a cause of the variation in recombination lifetime, some substance contained in silicon substrates themselves is suspected as a factor, and there is concern for an influence of impurities which are carbon or oxygen in particular.

Especially, in power devices in which the recombination lifetime of carriers is controlled by irradiating a silicon substrate with a particle beam of electrons or helium ions or the like, it has been pointed out that a very small amount of carbon which is 0.05 ppma or less adversely affects device characteristics (see Non Patent Documents 4 to 6). Thus, it has been considered that reducing the carbon contained in the silicon single crystal substrate as much as possible is important.

Furthermore, in Non Patent Document 1, it has been pointed out that, as a problem, wafer dependence occurs in the switching loss in some cases even if the same recombination lifetime control is carried out, and only CiOi among primary defects (CsI, CiCs, or CiOi) produced by electron beam irradiation has the wafer dependence in activation energy and activation tends to escalate when oxygen concentration is high, and hence it has been considered that oxygen impurities become a factor of the wafer dependence (where Cs: substitutional carbon, Ci: interstitial carbon, Oi: interstitial oxygen, and I: interstitial silicon).

However, actually, whether or not the carbon or oxygen impurities are the main factor of the variation in recombination lifetime has not been made clear.

Patent Document 6 discloses, as a method for controlling recombination lifetime, a controlling method in which the dopant concentration or both the dopant concentration and the oxygen concentration of a CZ silicon single crystal substrate are adjusted so that recombination lifetime can be controlled with high precision, and a recombination lifetime equivalent to that of an FZ silicon single crystal substrate can be obtained.

However, in Patent Document 6, there is a problem that the cause of the variation of and a method for controlling recombination lifetime in a nitrogen-added FZ silicon single crystal substrate are not clear.

Furthermore, Patent Document 7 discloses a method for selecting a silicon substrate that can reduce the variation in recombination lifetime caused by the silicon substrate and control recombination lifetime with high precision. In this method, a silicon substrate is judged to be acceptable when the ratio of the recombination lifetime after a particle beam irradiation step LT0 and the recombination lifetime after a recovery heat treatment LT1 (LT1/LT0) is a reference value LT2 or less.

However, in the method for selecting a silicon substrate disclosed in Patent Document 7, there is a problem that, as shown in FIG. 7 of Patent Document 7, an FZ silicon single crystal substrate that shows an oxygen concentration of 0.4 ppma or less has an extremely high probability of being judged as unacceptable. Moreover, there has been no effective technology that can reduce the variation in recombination lifetime even in the case of an FZ silicon single crystal substrate that shows an oxygen concentration of 0.4 ppma or less.

The present invention has been made in view of the above-described problem, and an object thereof is to provide a method for controlling recombination lifetime which can reduce a variation in recombination lifetime caused by a nitrogen-added FZ silicon single crystal substrate with certainty and highly precisely control the recombination lifetime in a power device manufacturing process where the recombination lifetime of carriers is controlled.

### SOLUTION TO PROBLEM

To solve the above-described problems, the present invention provides a method for controlling recombination lifetime for controlling recombination lifetime of carriers in a silicon single crystal substrate by performing: a preparation step of preparing a silicon single crystal substrate from a nitrogen-added silicon single crystal grown by a floating zone melting method (FZ method); a heat treatment step A of heat-treating the prepared silicon single crystal substrate; a particle beam irradiation step of irradiating the silicon single crystal substrate after the heat treatment step A with a particle beam; and a heat treatment step B of heat-treating the silicon single crystal substrate after the particle beam irradiation step, wherein
in the heat treatment step A, a nitrogen concentration Cn of the silicon single crystal substrate is adjusted in the heat treatment by outwardly diffusing nitrogen in the silicon single crystal substrate in accordance with an oxygen concentration Co of the silicon single crystal substrate prepared in the preparation step, then the particle beam irradiation step is performed on the silicon single crystal substrate with the adjusted nitrogen concentration Cn.

In this manner, by the heat treatment step A, the nitrogen concentration Cn of the silicon single crystal substrate is adjusted in the stage before the particle beam irradiation step in accordance with the oxygen concentration Co of the silicon single crystal substrate prepared from the nitrogen-added silicon single crystal grown by the FZ method (nitrogen-added FZ silicon single crystal substrate). When recombination lifetime is controlled in this way, variation in recombination lifetime caused by the silicon substrate can be reduced with certainty.

Furthermore, when the oxygen concentration Co of the silicon single crystal substrate prepared in the preparation step is less than 0.1 ppma, in the heat treatment step A, the heat treatment is performed to outwardly diffuse nitrogen so that the nitrogen concentration Cn of the silicon single crystal substrate after the heat treatment step A becomes less than 2×10¹⁴ atoms/cm³, and when the oxygen concentration Co of the silicon single crystal substrate prepared in the preparation step is 0.1 ppma or more, in the heat treatment step A, the heat treatment is performed to outwardly diffuse nitrogen so that the nitrogen concentration Cn of the silicon single crystal substrate after the heat treatment step A becomes less than 2×10¹⁵ atoms/cm³, and then the particle beam irradiation step is performed.

In this manner, by making adjustments in the heat treatment step A so that the nitrogen concentration Cn of the silicon single crystal substrate after the heat treatment step A (before the particle beam irradiation step) becomes less than 2×10¹⁹ atoms/cm³ when the oxygen concentration Co of the silicon single crystal substrate is less than 0.1 ppma, and by making adjustments in the heat treatment step A so that the nitrogen concentration Cn of the silicon single crystal substrate after the heat treatment step A (before the particle beam irradiation step) becomes less than 2×10¹⁵ atoms/cm³ when the oxygen concentration Co of the silicon single crystal substrate is 0.1 ppma or more, variation in recombination lifetime caused by the silicon single crystal substrate can be reduced with more certainty.

### ADVANTAGEOUS EFFECTS OF INVENTION

According to the inventive method for controlling recombination lifetime, since recombination lifetime can be controlled with high precision by adjusting the nitrogen concentration of the silicon single crystal substrate before the particle beam irradiation step in accordance with the oxygen concentration Co of the nitrogen-added FZ silicon single crystal substrate, the variation in recombination lifetime resulting from the silicon single crystal substrate can be reduced with certainty. Furthermore, since the nitrogen concentration of the silicon single crystal substrate before the particle beam irradiation step is adjusted in the heat treatment step after preparing the silicon single crystal substrate, there is no need to reduce the concentration of the nitrogen necessary for preventing an electric discharge in a furnace or suppressing the generation of crystal defects or the like at the time of silicon single crystal growth, and degradation of the productivity and quality of the silicon single crystal can be avoided. In addition, on controlling the recombination lifetime of a nitrogen-added FZ silicon substrate, the present invention can control the recombination lifetime with high precision even when the nitrogen concentration at the time of silicon single crystal growth is different, and is therefore particularly favorable when the nitrogen-added FZ silicon substrate is used for a power device.

### BRIEF DESCRIPTION OF DRAWINGS

FIG. 1 is a flow diagram showing the inventive method for controlling recombination lifetime in a silicon single crystal substrate.
FIG. 2 is some graphs showing the relation between the recombination lifetime LT measured in an Experimental Example and the heat treatment time of the heat treatment step B.
FIG. 3 is some graphs showing the relation between the recombination lifetime LT and the bulk nitrogen concentration after the heat treatment step A (before the particle beam irradiation step) measured in the Experimental Example when oxygen concentration was 0.1 ppma or more (FZ-A and FZ-B).
FIG. 4 is some graphs showing the relation between the recombination lifetime LT and the bulk nitrogen concentration after the heat treatment step A (before the particle beam irradiation step) measured in the Experimental Example when oxygen concentration was less than 0.1 ppma (FZ-C and FZ-D).

### DESCRIPTION OF EMBODIMENTS

Hereinafter, embodiments of the present invention will be described in detail, but the present invention is not limited thereto.

As described above, in conventional technology, the recombination lifetime of carriers is controlled by adjusting the conditions for particle beam irradiation and the conditions for the heat treatment after the particle beam irradiation, and in this case, there has been a problem that a variation in recombination lifetime occurs due to some factor caused by a silicon single crystal substrate.

The present inventor has earnestly studied and has found out that the recombination lifetime in a case where a particle beam irradiation and a subsequent heat treatment are performed on a silicon single crystal substrate varies even when carbon concentration, conventionally considered to be a cause of the variation, was almost the same, and that recombination lifetime strongly depends on the nitrogen concentration of the silicon single crystal substrate, and completed the present invention.

That is, it has been found that there is no problem of variation in recombination lifetime due to nitrogen in a silicon single crystal manufactured by an MCZ method since there is no need to manufacture with added nitrogen, but that it is necessary to add nitrogen to manufacture a silicon single crystal in an FZ method, and that this is a cause of the variation in the recombination lifetime of an FZ silicon single crystal substrate. Furthermore, it has been found that the nitrogen concentration dependence of recombination lifetime varies in accordance with oxygen concentration. Thus, by solving this problem peculiar to a silicon single crystal substrate manufactured by the FZ method, the present invention has been completed.

That is, the present invention is a method for controlling recombination lifetime for controlling recombination lifetime of carriers in a silicon single crystal substrate by performing: a preparation step of preparing a silicon single crystal substrate from a nitrogen-added silicon single crystal grown by a floating zone melting method (FZ method); a heat treatment step A of heat-treating the prepared silicon single crystal substrate; a particle beam irradiation step of irradiating the silicon single crystal substrate after the heat treatment step A with a particle beam; and a heat treatment step B of heat-treating the silicon single crystal substrate after the particle beam irradiation step, wherein

in the heat treatment step A, a nitrogen concentration Cn of the silicon single crystal substrate is adjusted in the heat treatment by outwardly diffusing nitrogen in the silicon single crystal substrate in accordance with an oxygen concentration Co of the silicon single crystal substrate prepared in the preparation step, then the particle beam irradiation step is performed on the silicon single crystal substrate with the adjusted nitrogen concentration Cn.

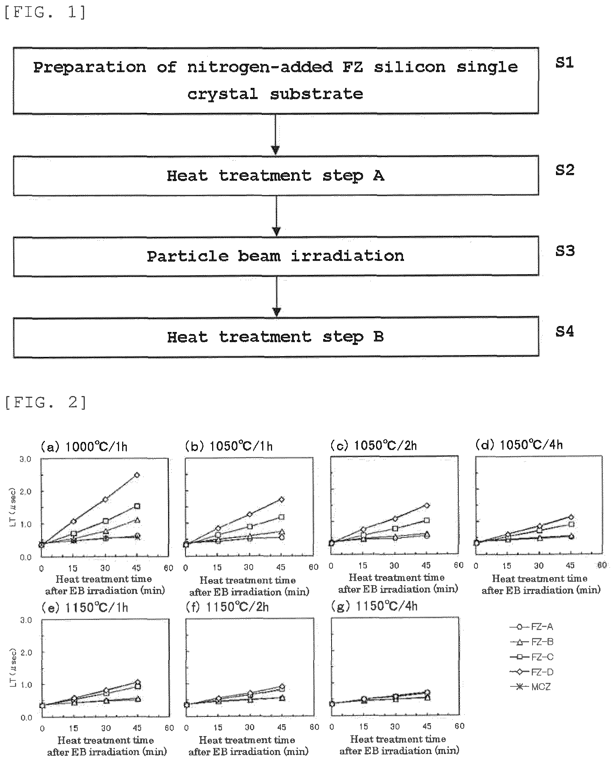

Hereinafter, the inventive method for controlling recombination lifetime will be described with reference to FIG. 1.

Firstly, a silicon single crystal substrate is prepared from a nitrogen-added silicon single crystal grown by the FZ method (S1 of FIG. 1). The specifications (diameter, thickness, resistivity, etc.) of the silicon single crystal substrate prepared here are not particularly limited in the present invention. For example, the specifications can be set in accordance with requirements from the semiconductor device side.

In addition, the method for preparing this silicon single crystal substrate is not particularly limited in the present invention. For example, the silicon single crystal substrate can be prepared by slicing off a silicon wafer from a silicon single crystal, performing a chemical etching treatment on the silicon wafer to eliminate slicing damage, and then performing chemical-mechanical polishing.

Next, a heat treatment step A of heat-treating the silicon single crystal substrate is performed (S2 of FIG. 1) .

In this heat treatment step A, the nitrogen concentration of the silicon single crystal substrate is adjusted before the particle beam irradiation step by outwardly diffusing the nitrogen in the silicon single crystal substrate in accordance with the oxygen concentration Co of the silicon single crystal substrate prepared in the preparation step.

The conditions for the heat treatment step A are determined in accordance with the oxygen concentration Co of the silicon single crystal substrate prepared in the preparation step, and when the oxygen concentration Co of the silicon single crystal substrate prepared in the preparation step is less than 0.1 ppma, the conditions are preferably determined so that the nitrogen concentration Cn after the heat treatment step A becomes less than 2×10¹⁴ atoms/cm³. Meanwhile, when the oxygen concentration Co of the silicon single crystal substrate prepared in the preparation step is 0.1 ppma or more, the conditions are preferably determined so that the nitrogen concentration Cn after the heat treatment step A becomes less than 2×10¹⁵ atoms/cm³.

The upper limit of the oxygen concentration Co of the silicon single crystal substrate prepared from the nitrogen-added silicon single crystal grown by the FZ method is not particularly limited, but can be, for example, less than 1 ppma.

In a case of any oxygen concentration Co, the lower limit of the nitrogen concentration Cn is not limited. Here, the nitrogen concentration after the heat treatment step A is the nitrogen concentration in a region where recombination lifetime is to be adjusted. When the silicon single crystal substrate is thinned by grinding or the like before the particle beam irradiation step in a semiconductor device manufacturing process, the nitrogen concentration is the nitrogen concentration in a region where recombination lifetime is to be adjusted after the thinning.

Furthermore, the heat treatment step A is not limited to one heat treatment step, and the heat treatment step may be performed multiple times. The heat treatment step A may be performed before the semiconductor device manufacturing process, or may be performed during the semiconductor device manufacturing process. Furthermore, the heat treatment step A may be performed by a combination of heat treatment steps before the semiconductor device manufacturing process and during the manufacturing process.

The important thing in the heat treatment step A is to adjust the nitrogen concentration Cn of the silicon single crystal substrate before the particle beam irradiation step by outwardly diffusing the nitrogen in the silicon single crystal substrate in accordance with the oxygen concentration Co of the silicon single crystal substrate prepared in the preparation step, in particular, so that the relation between the oxygen concentration Co of the silicon single crystal substrate prepared in the preparation step and the nitrogen concentration Cn of the silicon single crystal substrate before the particle beam irradiation step satisfies the above-described conditions.

In this manner, the variation in recombination lifetime caused by the nitrogen-added FZ silicon single crystal substrate can be reduced with certainty, and the recombination lifetime can be controlled with high precision. On the other hand, if the heat treatment is performed under the same conditions without considering the adjustment of the nitrogen concentration before the particle beam irradiation step and regardless of the oxygen concentration Co of the silicon single crystal substrate, a case in which the variation in recombination lifetime caused by the nitrogen-added FZ silicon single crystal substrate becomes large sometimes occurs.

The heat treatment step A may be under any conditions so long as the nitrogen in the silicon single crystal substrate can be outwardly diffused and the conditions are determined in accordance with the oxygen concentration Co of the silicon single crystal substrate prepared in the preparation step, but in particular, the heat treatment conditions are preferably set so that the relation between the oxygen concentration Co of the silicon single crystal substrate prepared in the preparation step and the nitrogen concentration Cn of the silicon single crystal substrate before the particle beam irradiation step satisfies the above-described conditions. For example, when the heat treatment step A is performed in one heat treatment, the conditions can be determined in accordance with the oxygen concentration Co of the silicon single crystal substrate with the temperature as 1050°C or more and the time as 2 hours or more. The higher the temperature of the heat treatment in the heat treatment step A, the faster the diffusion rate of the nitrogen, which is efficient. The nitrogen concentration of the silicon single crystal substrate decreases the higher the temperature and the longer the time of the heat treatment step A.

Since the lower limit of the nitrogen concentration of the silicon single crystal substrate after the heat treatment step A is not limited in the present invention, the upper limits of the heat treatment temperature and the time of the heat treatment step A are not limited. The upper limits can be determined taking into consideration other qualities such as productivity, cost, or prevention of slip dislocation from occurring.

Patent Document 6 and Patent Document 7 disclose that when oxide film passivation is employed to suppress surface recombination in a measurement step of measuring recombination lifetime, an oxide film can be formed on the surface of the silicon single crystal substrate before the particle beam irradiation step. It is also disclosed that the oxide film can be formed by a heat treatment in an oxidizing atmosphere, and that the conditions for the oxide-film-forming heat treatment can be, for example: a temperature of 900°C or more and 1100°C or less and a time of 10 minutes or more and 60 minutes or less. Furthermore, it is disclosed that employing chemical passivation which does not accompany a heat treatment, and not employing oxide film passivation is also possible.

The nitrogen in the silicon single crystal substrate is also outwardly diffused in the oxide-film-forming heat treatment for oxide film passivation described in Patent Document 6 and Patent Document 7. However, these heat treatment conditions are not determined in accordance with the oxygen concentration Co of the silicon single crystal substrate, and the conditions for the oxide-film-forming heat treatment described in Patent Document 6 and Patent Document 7 are sometimes insufficient for achieving the object of the heat treatment step A in the present invention, and as a result, cases occur in which the variation in recombination lifetime caused by the silicon single crystal substrate cannot be reduced.

Essentially, in order to control recombination lifetime strictly, the relation between the oxygen concentration and the nitrogen concentration of the silicon single crystal substrate at the stage of performing the particle beam irradiation is important. However, since the diffusion rate of oxygen in a silicon single crystal substrate is low, the bulk oxygen concentration after the heat treatment step A (before the particle beam irradiation step) is hardly changed from the initial oxygen concentration at the stage of preparation in the preparation step. For this reason, in the present invention, the oxygen concentration Co of the silicon single crystal substrate prepared in the preparation step can be treated as being the same as the oxygen concentration Co of the silicon single crystal substrate after the heat treatment step A (before the particle beam irradiation step).

Next, a particle beam irradiation step of irradiating the silicon single crystal substrate after the heat treatment step A with a particle beam (S3 of FIG. 1) and a heat treatment step B of performing a heat treatment after the particle beam irradiation step (S4 of FIG. 1) are performed.

The conditions for the particle beam irradiation step and the heat treatment step B performed here are not particularly limited in the present invention. The conditions can be determined so as to fulfill requirements from the semiconductor device side, and for example, in the particle beam irradiation step, an electron beam can be used for irradiation as the particle beam with a dosage of 1×10¹⁴ to 3×10¹⁵/cm² and an acceleration voltage of 0.5 to 2 MeV. Protons or helium ions can also be used for irradiation.

The heat treatment step B is a heat treatment step for eliminating part of the recombination centers generated in the particle beam irradiation step to allow the recombination lifetime to recover, and for example, the temperature may be set to 300 to 400°C, the time to 10 to 60 minutes, and the atmosphere may be nitrogen, oxygen or hydrogen or the like.

The inventive method for controlling recombination lifetime as described above can highly precisely control recombination lifetime and reduce the variation in recombination lifetime resulting from silicon single crystal substrate with certainty.

In the present invention, a reason to use the above-described method for controlling recombination lifetime to highly precisely control recombination lifetime and reduce the variation in lifetime resulting from the silicon single crystal substrate with certainty is based on the knowledge obtained by an experiment described below.

### (Experimental Example)

Silicon single crystal substrates were prepared from a plurality of nitrogen-added silicon single crystals grown by the FZ method (also referred to as FZ substrates). In addition, for comparison, a silicon single crystal substrate was prepared from a non-nitrogen-added silicon single crystal grown by the MCZ method (also referred to as an MCZ substrate). Each of the silicon single crystal substrates had a diameter of 200 mm, a crystal plane orientation of (100), a thickness of 720 to 730 µm, a conductivity type of n type (with added phosphorous), and a resistivity of 63 to 71 Ω·cm.

The oxygen concentration, carbon concentration, and nitrogen concentration of each silicon single crystal substrate are as in the following Table. The oxygen concentration was measured by an infrared absorption method (conversion factor: JEIDA), and the carbon concentration and the nitrogen concentration were measured by secondary ion mass spectrometry (SIMS). Each concentration shown in the Table is the concentration at the stage when the silicon single crystal substrates were prepared (before the heat treatment step A)(also referred to as initial concentration).

**[Table 1]**

| | Oxygen concentration (ppma) | Carbon concentration (atoms/cm³) | Nitrogen concentration (atoms/cm³) |
|---|---|---|---|
| FZ-A | 0.3 | 8.0×10¹⁴ | 3.9×10¹⁴ |
| FZ-B | 0.2 | 8.2×10¹⁴ | 3.1×10¹⁵ |
| FZ-C | <0.1 | 7.2×10¹⁴ | 3.6×10¹⁴ |
| FZ-D | <0.1 | 9.8×10¹⁴ | 2.3×10¹⁵ |
| MCZ | 3.9 | 8.2×10¹⁴ | - |

The FZ substrates with an oxygen concentration of 0.1 ppma or more (FZ-A and FZ-B) were manufactured from silicon single crystals grown by the FZ method with silicon single crystal ingots grown by the CZ method as starting materials. Meanwhile, the FZ substrates with an oxygen concentration of less than 0.1 ppma (FZ-C and FZ-D) were manufactured from silicon single crystals grown by the FZ method with ordinary polycrystalline silicon ingots as starting materials.

Next, the prepared silicon single crystal substrates were heat-treated (heat treatment step A). The heat treatment conditions (temperature/time) were set to 1000°C/1 hour, 1050°C/1 hour, 1050°C/2 hours, 1050°C/4 hours, 1150°C/1 hour, 1150°C/2 hours, 1150°C/4 hours, and the atmosphere was oxygen. As for the MCZ substrate, however, the heat treatment was only performed under the conditions of 1000°C/1 hour since nitrogen was not added. Under each of the heat treatment conditions for the heat treatment step A, the silicon single crystal substrate was introduced into a furnace maintained at 900°C, the temperature was raised to each temperature from 900°C at a rate of 5°C/minute, and after each temperature was maintained for each time, the temperature was lowered from each temperature to 900°C at a rate of -3°C/minute, and the silicon single crystal substrates were taken out of the furnace.

Next, the silicon single crystal substrates after the heat treatment step A were irradiated with an electron beam (particle beam irradiation step). In this event, the irradiation dosage of the electron beam was set to 1×10¹⁵/cm² and the acceleration voltage of the electron beam was set to 2 MV.

In addition, a different silicon single crystal substrate on which the heat treatment step A was performed at the same time as the silicon single crystal substrates irradiated with the electron beam was polished to remove approximately half the thickness from the front side (about 360 µm), then the nitrogen concentration was measured by SIMS, and thus, the bulk nitrogen concentration (the nitrogen concentration near the center of the substrate in a thickness direction) after the heat treatment step A (before the particle beam irradiation step) was determined.

Next, a recovery heat treatment was performed on the silicon single crystal substrate irradiated with the electron beam (heat treatment step B). The temperature of the heat treatment was set to 360°C, the atmosphere to nitrogen, and the time was made to range from 0 to 45 minutes. Subsequently, recombination lifetime (LT) was measured.

Microwave Photo Conductive Decay method (µ-PCD method) was used for measuring recombination lifetime. In this µ-PCD method, firstly, a light pulse having a greater energy than the bandgap of a silicon single crystal is used for irradiation so that excessive carriers are generated in a silicon single crystal substrate. Conductivity of a wafer increases due to the generated excessive carriers, but subsequently, conductivity decreases with the passage of time because of excessive carriers disappearing due to recombination. By detecting this change as change in reflective microwave power with time (excessive carrier decay curve) and analyzing, recombination lifetime can be determined.

Recombination lifetime is defined as the time it takes until excessive carrier concentration decays to 1/e (=0.368) due to recombination (JEIDA-53-1997 "Recombination Lifetime Measuring Method for Silicon Wafer based on Reflective Microwave Photoconductive Decay method"). In the present experiment, the time it takes until the reflective microwave power decays to 1/e of the reflective microwave power at the time of light pulse irradiation (1/e lifetime) was determined as the recombination lifetime. As the measuring apparatus, a commercially available apparatus was used.

The relation between recombination lifetime LT and the heat treatment time of the heat treatment step B is shown in FIG. 2. The conditions for the heat treatment step A (temperature/time) are: 1000°C/1 hour in FIG. 2 (a), 1050°C/1 hour in FIG. 2 (b), 1050°C/2 hours in FIG. 2 (c), 1050°C/4 hours in FIG. 2 (d), 1150°C/1 hour in FIG. 2 (e), 1150°C/2 hours in FIG. 2 (f), and 1150°C/4 hours in FIG. 2 (g). The difference in the symbols in FIG. 2 shows the difference in silicon single crystal substrates, and "∘" indicates a case with FZ-A, "Δ" with FZ-B, "□" with FZ-C, "0" with FZ-D, and "*" with MCZ.

It can be observed from FIG. 2 that in the case where the conditions for the heat treatment step A are 1000°C/1 hour [FIG. 2 (a)], the change in LT in relation to the heat treatment time of the heat treatment step B differs greatly depending on the difference in silicon single crystal substrate. This indicates that LT varies greatly due to the silicon single crystal substrate even when the conditions for the electron beam irradiation and the subsequent recovery heat treatment are the same. It can also be observed that the higher the nitrogen concentration and the lower the oxygen concentration of the FZ substrate before the heat treatment step A, the larger the amount of change in LT in relation to the heat treatment time of the heat treatment step B. This indicates that even when the carbon concentration of the FZ substrate is almost the same, LT greatly varies depending on nitrogen concentration and oxygen concentration, and indicates that, in an FZ substrate, nitrogen concentration and oxygen concentration are the main factors of LT variation. Furthermore, as the heat treatment temperature of the heat treatment step A becomes higher and the heat treatment time of the heat treatment step A becomes longer, the change in LT in relation to the heat treatment time of the heat treatment step B becomes smaller, and it can be observed that the variation in LT due to the difference between the FZ substrates becomes extremely small and the difference in LT due to the difference between an FZ substrate and a non-nitrogen-added MCZ substrate also becomes extremely small.

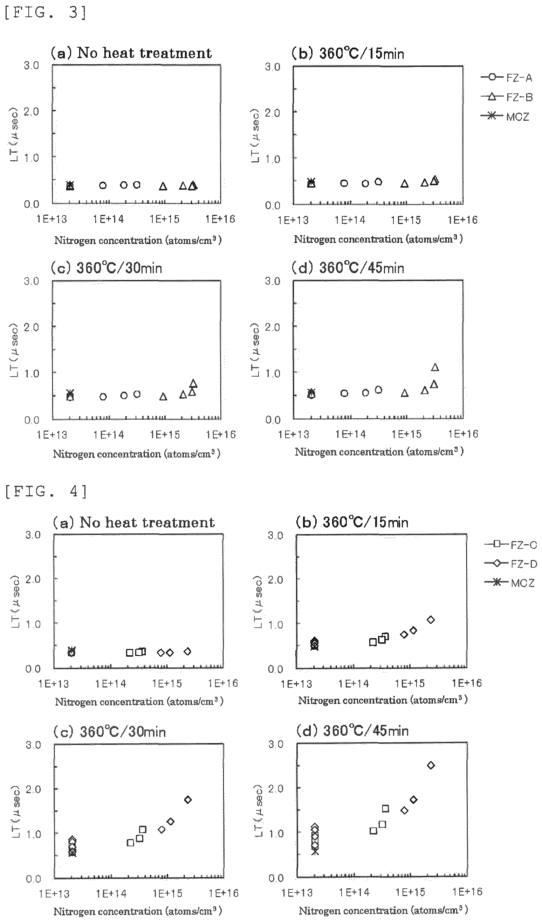

Next, regarding the cases of the FZ substrates with an oxygen concentration of 0.1 ppma or more (FZ-A and FZ-B), the relation between recombination lifetime LT and the bulk nitrogen concentration after the heat treatment step A (before the particle beam irradiation step) is shown in FIG. 3. The conditions for the heat treatment step B (temperature/time) are: no heat treatment in (a), 360°C/15 minutes in (b), 360°C/30 minutes in (c), and 360°C/45 minutes in (d). The difference in the symbols in FIG. 3 shows the difference in FZ substrates, and "∘" indicates a case with FZ-A and "Δ" with FZ-B. In addition, a case with a non-nitrogen-added MCZ substrate has been indicated with "*" for comparison. In FIG. 3, when the bulk nitrogen concentration was the lower limit for detection (4×10¹³ atoms/cm³) or less, the bulk nitrogen concentration has been plotted as 2×10¹³ atoms/cm³ for convenience.

It can be observed from FIG. 3 that with an oxygen concentration of 0.1 ppma or more, LT becomes longer along with the bulk nitrogen concentration as the heat treatment time of the heat treatment step B becomes longer [FIG. 3 (c) and FIG. 3 (d)], but that when the bulk nitrogen concentration is 2×10¹⁵ atoms/cm³ or less, LT does not depend on the bulk nitrogen concentration. That is, it can be observed that when the oxygen concentration is 0.1 ppma or more, by adjusting the bulk nitrogen concentration to 2×10¹⁵ atoms/cm³ or less before the particle beam irradiation step in the heat treatment step A, the variation in LT due to the difference between the FZ substrates becomes extremely small and the difference in LT due to the difference between an FZ substrate and a non-nitrogen-added MCZ substrate can also be made extremely small.

Next, regarding the cases with an oxygen concentration of less than 0.1 ppma (FZ-C and FZ-D), the relation between recombination lifetime LT and the bulk nitrogen concentration after the heat treatment step A (before the particle beam irradiation step) is shown in FIG. 4. The conditions for the heat treatment step B (temperature/time) are: no heat treatment in (a), 360°C/15 minutes in (b), 360°C/30 minutes in (c), and 360°C/45 minutes in (d). The difference in the symbols in FIG. 4 shows the difference in FZ substrates, and "□" indicates a case with FZ-C and "0" with FZ-D. In addition, a case with a non-nitrogen-added MCZ substrate has been indicated with "*" for comparison. In FIG. 4, when the bulk nitrogen concentration was the lower limit for detection (4×10¹³ atoms/cm³) or less, the bulk nitrogen concentration has been plotted as 2×10¹³ atoms/cm³ for convenience.

It can be observed from FIG. 4 that with an oxygen concentration of less than 0.1 ppma, dependence of LT on bulk nitrogen concentration becomes stronger as the heat treatment time of the heat treatment step B becomes longer, but that when the bulk nitrogen concentration is 2×10¹⁹ atoms/cm³ or less, LT hardly depends on bulk nitrogen concentration. That is, it can be observed that when the oxygen concentration is less than 0.1 ppma, by adjusting the bulk nitrogen concentration to 2×10¹⁹ atoms/cm³ or less before the particle beam irradiation step in the heat treatment step A, the variation in LT due to the difference between the FZ substrates becomes extremely small and the difference in LT due to the difference between an FZ substrate and a non-nitrogen-added MCZ substrate can also be made extremely small.

Furthermore, it can be observed from the results of FIG. 3 and FIG. 4 put together that when the oxygen concentration is 0.3 ppma or less, by adjusting the bulk nitrogen concentration of the FZ substrate to 2×10¹⁴ atoms/cm³ or less in the stage before the particle beam irradiation step in the heat treatment step A, recombination lifetime can be highly precisely controlled regardless of the difference in starting material at the time of crystal growth of the FZ silicon single crystals, the difference in nitrogen concentration, and furthermore, the difference between the FZ method and the non-nitrogen-added MCZ method.

As described above, by adjusting the nitrogen concentration of the silicon single crystal substrate before the particle beam irradiation step in accordance with the oxygen concentration of the silicon single crystal substrate for controlling recombination lifetime, it is possible to control recombination lifetime with high precision, and therefore, the variation in recombination lifetime caused by the silicon single crystal substrate can be reduced with certainty. Furthermore, since the nitrogen concentration of the silicon single crystal substrate before the particle beam irradiation step is adjusted in the heat treatment step A after preparing the silicon single crystal substrate, there is no need to reduce the concentration of the nitrogen necessary for preventing an electric discharge in a furnace or suppressing the generation of crystal defects or the like at the time of silicon single crystal growth, and degradation of the productivity and quality of the silicon single crystal can be avoided.

A reason why the recombination lifetime when the electron beam irradiation and the subsequent heat treatment have been performed is dependent upon the nitrogen concentration as described above can be considered as follows.

When the silicon substrate is irradiated with a particle beam having high energy, a silicon atom at a lattice position is flicked out, and interstitial silicon (referred to as I hereinafter) and a vacancy (referred to as V hereinafter) which is an empty shell thereof are produced. Since the excessively produced I or V is unstable when it is alone, they recombine (V+I→O), clustering of Is or clustering of Vs occurs, or they react with a light element impurity contained in the silicon substrate to form a composite. Additionally, the cluster of I or V or the composite of I or V and the light element impurity forms a deep level in a bandgap of silicon, functions as a recombination center of carriers, and decreases the recombination lifetime.

It has been known that, as a defect concerning the vacancy V, V and a substitutional phosphorous Ps react to form VP (V+Ps→VP). Further, V and the interstitial oxygen Oi react to form VO (V+Oi→VO), and further, V and VO react to form V₂O (V+VO→V₂O) in some cases. Furthermore, a pair of V react to form VV (V+V→VV). When nitrogen is present, V and N react to form VN (V+N→VN). Since reactions of V and P, O, or N compete against each other, if VN is apt to be formed when the nitrogen concentration is high, there is a possibility that other composites to which V relates are not easily formed.

On the other hand, it has been known that, as defects to which the interstitial silicon I relates, I and substitutional boron Bs react to form interstitial boron Bi (I+Bs->Bi), and further, Bi and Oi react to form BiOi (Bi+Oi→BiOi). Furthermore, when carbon is present, I and the substitutional carbon Cs react to form interstitial carbon Ci (I+Cs→Ci), and further, Ci and Oi or Ci and Cs react to form CiOi or CiCs (Ci+Oi→CiOi, Ci+Cs→CiCs). Moreover, I also reacts with other I to form an I cluster (I+I+...→In). When nitrogen is present, a reaction of V and N suppresses the recombination of V and I, and hence there is a possibility that a composite to which I relates is apt to be formed.

Since the reaction of I or V and a light element impurity is dependent on each absolute concentration and a concentration balance, it is very complicated, and estimating which composite becomes dominant is difficult. Additionally, when the heat treatment has been performed, annihilation or morphological transformation of the composites occurs, resulting in further complexity.

As illustrated with the above Experimental Example, when the nitrogen concentration of the silicon single crystal substrate increases, thermally unstable composites are apt to be formed by the irradiation with the particle beam having high energy, and therefore, it can be considered that the composites are readily annihilated by the subsequent heat treatment and the recombination lifetime after the heat treatment increases.

### EXAMPLE

Hereinafter, the present invention will be more specifically described with reference to Examples of the present invention and Comparative Examples, but the present invention is not limited thereto.

### (Example)

A recombination lifetime of each silicon single crystal substrate was controlled by the inventive method for controlling recombination lifetime as shown in FIG. 1.

Firstly, four levels of FZ substrates with different oxygen concentrations and nitrogen concentrations (FZ-A, FZ-B, FZ-C, and FZ-D) were prepared in the preparation step. The oxygen concentration was 0.3 ppma in FZ-A, 0.2 ppma in FZ-B, and less than 0.1 ppma in FZ-C and FZ-D, and the nitrogen concentration was 3.9×10¹⁴ atoms/cm³ in FZ-A, 3.1×10¹⁵ atoms/cm³ in FZ-B, 3.6×10¹⁴ atoms/cm³ in FZ-C, and 2.3×10¹⁵ atoms/cm³ in FZ-D.

Next, the prepared FZ substrates were heat-treated (heat treatment step A).

With the FZ substrates having an oxygen concentration of 0.1 ppma or more (FZ-A and FZ-B), the heat treatment step A was performed so that the bulk nitrogen concentration before the particle beam irradiation step became 2×10¹⁵ atoms/cm³ or less. In this case, the temperature of the heat treatment step A was set to 1050°C, the time to 4 hours, and the atmosphere to oxygen. In this heat treatment, the FZ substrates were introduced into a furnace maintained at 900°C, the temperature was raised from 900°C to 1050°C at a rate of 5°C/minute, and after maintaining at 1050°C for 4 hours, the temperature was lowered from 1050°C to 900°C at a rate of -3°C/minute, and the FZ substrates were taken out of the furnace.

Meanwhile, with the FZ substrates having an oxygen concentration of less than 0.1 ppma (FZ-C and FZ-D), the heat treatment step A was performed so that the bulk nitrogen concentration before the particle beam irradiation step became 2×10¹⁴ atoms/cm³ or less. In this case, the temperature of the heat treatment step A was set to 1150°C, the time to 4 hours, and the atmosphere to oxygen. In this heat treatment, the FZ substrates were introduced into a furnace maintained at 900°C, the temperature was raised from 900°C to 1150°C at a rate of 5°C/minute, and after maintaining at 1150°C for 4 hours, the temperature was lowered from 1150°C to 900°C at a rate of -3°C/minute, and the FZ substrates were taken out of the furnace.

Next, the FZ substrates after the heat treatment step A were irradiated with an electron beam (particle beam irradiation step). In this event, the irradiation dosage of the electron beam was set to 1×10¹⁵/cm² and the acceleration voltage of the electron beam was set to 2 MV.

A different FZ substrate on which the heat treatment step A was performed at the same time as the FZ substrates irradiated with the electron beam was polished to remove approximately half the thickness from the front side (about 360 µm), then the bulk nitrogen concentration was measured by SIMS. As a result, the bulk nitrogen concentrations of the FZ substrates having an oxygen concentration of 0.1 ppma or more were: the lower limit for detection (4×10¹³ atoms/cm³) or less in the case of FZ-A, and 9.1×10¹⁴ atoms/cm³ in the case of FZ-B. Thus, it was confirmed that the bulk nitrogen concentrations satisfied the condition of 2×10¹⁵ atoms/cm³ or less. In addition, the bulk nitrogen concentrations of the FZ substrates having an oxygen concentration of less than 0.1 ppma were: the lower limit for detection (4×10¹³ atoms/cm³) or less in both the cases of FZ-C and FZ-D. Thus, it was confirmed that the bulk nitrogen concentration satisfied the condition of 2×10¹⁴ atoms/cm³ or less.

Next, a recovery heat treatment was performed on the FZ substrate irradiated with the electron beam (heat treatment step B). The temperature of the recovery heat treatment was set to 360°C, the time to 30 minutes, and the atmosphere to nitrogen.

Next, the recombination lifetime (LT) after the heat treatment step B was measured by the µ-PCD method. The result was: 0.5 µsec in FZ-A, 0.5 µsec in FZ-B, 0.6 µsec in FZ-C, and 0.6 µsec in FZ-D. Thus, it was confirmed that the variation in LT due to the difference between the FZ substrates was extremely small.

### (Comparative Example)

Except that the nitrogen concentration before the particle beam irradiation step was not adjusted in accordance with the oxygen concentrations of the silicon single crystal substrates, recombination lifetime of the silicon single crystal substrates was controlled under the same conditions as the Example.

Firstly, the same four levels of FZ substrates as in the Example (FZ-A, FZ-B, FZ-C, and FZ-D) were prepared in the preparation step.

Next, the prepared FZ substrates were heat-treated (heat treatment step A').

In this heat treatment step A', adjustment of the nitrogen concentration before the particle beam irradiation step was not taken into consideration, and every FZ substrate was heat-treated under the same conditions with the temperature set to 1000°C, the time to 1 hour, and the atmosphere to oxygen. In this heat treatment, the FZ substrates were introduced into a furnace maintained at 900°C, the temperature was raised from 900°C to 1000°C at a rate of 5°C/minute, and after maintaining at 1000°C for 1 hour, the temperature was lowered from 1000°C to 900°C at a rate of -3°C/minute, and the FZ substrates were taken out of the furnace.

Next, the electron beam irradiation (particle beam irradiation step) was performed, and the recovery heat treatment (heat treatment step B) was performed under the same conditions as in the Example.

A different FZ substrate on which the heat treatment step A' was performed at the same time as the FZ substrates irradiated with the electron beam was polished to remove approximately half the thickness from the front side (about 360 µm), then the bulk nitrogen concentration was measured by SIMS. The results were: 3.1×10¹⁴ atoms/cm³ in FZ-A, 3.1×10¹⁵ atoms/cm³ in FZ-B, 3.6×10¹⁹ atoms/cm³ in FZ-C, and 2.3×10¹⁵ atoms/cm³ in FZ-D, and the FZ substrates other than FZ-A did not satisfy the above-described conditions of the present invention.

Next, the recombination lifetime (LT) after the heat treatment step B was measured by the µ-PCD method. The results were: 0.6 µsec in FZ-A, 0.8 µsec in FZ-B, 1.1 µsec in FZ-C, and 1.8 µsec in FZ-D. Thus, it was confirmed that the variation in LT due to the difference between the FZ substrates became large.

## Claims

1. A method for controlling recombination lifetime for controlling recombination lifetime of carriers in a silicon single crystal substrate by performing:
a preparation step of preparing a silicon single crystal substrate from a nitrogen-added silicon single crystal grown by a floating zone melting method (FZ method);
a heat treatment step A of heat-treating the prepared silicon single crystal substrate;
a particle beam irradiation step of irradiating the silicon single crystal substrate after the heat treatment step A with a particle beam; and
a heat treatment step B of heat-treating the silicon single crystal substrate after the particle beam irradiation step, wherein
in the heat treatment step A, a nitrogen concentration Cn of the silicon single crystal substrate is adjusted in the heat treatment by outwardly diffusing nitrogen in the silicon single crystal substrate in accordance with an oxygen concentration Co of the silicon single crystal substrate prepared in the preparation step, then the particle beam irradiation step is performed on the silicon single crystal substrate with the adjusted nitrogen concentration Cn, wherein
when the oxygen concentration Co of the silicon single crystal substrate prepared in the preparation step is less than 0.1 ppma, in the heat treatment step A, the heat treatment is performed to outwardly diffuse nitrogen so that the nitrogen concentration Cn of the silicon single crystal substrate after the heat treatment step A becomes less than 2×10¹⁴ atoms/cm³, and when the oxygen concentration Co of the silicon single crystal substrate prepared in the preparation step is 0.1 ppma or more, in the heat treatment step A, the heat treatment is performed to outwardly diffuse nitrogen so that the nitrogen concentration Cn of the silicon single crystal substrate after the heat treatment step A becomes less than 2×10¹⁵ atoms/cm³, and
then the particle beam irradiation step is performed.

## Patentansprüche

1. Verfahren zum Steuern einer Rekombinationslebensdauer zum Steuern einer Rekombinationslebensdauer von Ladungsträgern in einem Silizium-Einkristallsubstrat durch Ausführen:
eines Herstellungsschritts zum Herstellen eines Silizium-Einkristallsubstrats aus einem mit Stickstoff versetzten Silizium-Einkristall, der durch ein Floating-Zone-Schmelz-Verfahren (FZ-Verfahren) gezüchtet wurde;
eines Wärmebehandlungsschritts A zum Wärmebehandeln des hergestellten Silizium-Einkristallsubstrats;
eines Teilchenstrahl-Bestrahlungsschritts zum Bestrahlen des Silizium-Einkristallsubstrats nach dem Wärmebehandlungsschritt A mit einem Teilchenstrahl; und
eines Wärmebehandlungsschritts B zum Wärmebehandeln des Silizium-Einkristallsubstrats nach dem Teilchenstrahl-Bestrahlungsschritt, wobei
in dem Wärmebehandlungsschritt A eine Stickstoffkonzentration Cn des Silizium-Einkristallsubstrats bei der Wärmebehandlung durch Ausdiffundieren von Stickstoff in das Silizium-Einkristallsubstrat in Übereinstimmung mit einer Sauerstoffkonzentration Co des in dem Herstellungsschritt hergestellten Silizium-Einkristallsubstrats eingestellt wird, dann der Teilchenstrahl-Bestrahlungsschritt auf dem Silizium-Einkristallsubstrat mit der eingestellten Stickstoffkonzentration Cn durchgeführt wird, wobei
wenn die Sauerstoffkonzentration Co des im Herstellungsschritt hergestellten Silizium-Einkristallsubstrats weniger als 0,1 ppma beträgt, im Wärmebehandlungsschritt A die Wärmebehandlung durchgeführt wird, um Stickstoff auszudiffundieren, so dass die Stickstoffkonzentration Cn des Silizium-Einkristallsubstrats nach dem Wärmebehandlungsschritt A weniger als 2×10¹⁴ Atome/cm³ wird, und wenn die Sauerstoffkonzentration Co des im Herstellungsschritt hergestellten Silizium-Einkristallsubstrats 0,1 ppma oder mehr beträgt, wird in dem Wärmebehandlungsschritt A die Wärmebehandlung durchgeführt, um Stickstoff auszudiffundieren, so dass die Stickstoffkonzentration Cn des Silizium-Einkristallsubstrats nach dem Wärmebehandlungsschritt A weniger als 2×10¹⁵ Atome/cm³ wird, und
dann wird der Teilchenstrahl-Bestrahlungsschritt durchgeführt.

## Revendications

1. Procédé de commande de la durée de vie de recombinaison pour commander la durée de vie de recombinaison de porteurs dans un substrat de monocristal de silicium par réalisation :
d'une étape de préparation consistant à préparer un substrat de monocristal de silicium à partir d'un monocristal de silicium additionné d'azote cultivé par un procédé de fusion en zone flottante (procédé FZ) ;
d'une étape de traitement thermique A consistant à traiter thermiquement le substrat de monocristal de silicium préparé ;
d'une étape d'irradiation par faisceau de particules consistant à irradier le substrat de monocristal de silicium après l'étape de traitement thermique A avec un faisceau de particules ; et
d'une étape de traitement thermique B consistant à traiter thermiquement le substrat de monocristal de silicium après l'étape d'irradiation par faisceau de particules, dans lequel,
dans l'étape de traitement thermique A, une concentration en azote Cn du substrat de monocristal de silicium est ajustée lors du traitement thermique par diffusion d'azote vers l'extérieur dans le substrat de monocristal de silicium selon une concentration en oxygène Co du substrat de monocristal de silicium préparé à l'étape de préparation, puis l'étape d'irradiation par faisceau de particules est effectuée sur le substrat de monocristal de silicium avec la concentration en azote ajustée Cn, dans lequel
lorsque la concentration en oxygène Co du substrat de monocristal de silicium préparé à l'étape de préparation est inférieure à 0,1 ppma, à l'étape de traitement thermique A, le traitement thermique est effectué pour diffuser de l'azote vers l'extérieur de sorte que la concentration en azote Cn du substrat de monocristal de silicium après l'étape de traitement thermique A devienne inférieure à 2 × 10¹⁴ atomes/cm³, et lorsque la concentration en oxygène Co du substrat de monocristal de silicium préparé à l'étape de préparation est de 0,1 ppma ou plus, à l'étape de traitement thermique A, le traitement thermique est effectué pour diffuser de l'azote vers l'extérieur de sorte que la concentration en azote Cn du substrat de monocristal de silicium après l'étape de traitement thermique A devienne inférieure à 2 × 10¹⁵ atomes/cm³, et
ensuite l'étape d'irradiation par faisceau de particules est réalisée.
